# EUROPÄISCHE PATENTSCHRIFT

(11) **EP 0 556 732 B1**
(45) Veröffentlichungstag und Bekanntmachung des Hinweises auf die Patenterteilung: **06.05.1999**
(21) Anmeldenummer: 93102193.5
(22) Anmeldetag: 12.02.1993
(51) Int. Cl.: G03F 3/10

(54) **Verfahren zur Herstellung eines Mehrfarbenbilds und lichtempfindliches Material zur Durchführung dieses Verfahrens**
Method for producing a multicoloured image and photosensitive material for implementing this method
Procédé pour fabriquer une image multicolore et matériel photosensible pour la mise en oeuvre de ce procédé

(30) Priorität: 19.02.1992 DE 4204950
(43) Veröffentlichungstag der Anmeldung: 25.08.1993
(73) Patentinhaber: Agfa-Gevaert AG, 51373 Leverkusen (DE)
(72) Erfinder: Platzer, Stephan J.W., Dr., W-6228 Eltville/Erbach (DE); Nürnberger, Siegfried, W-6228 Eltville-Martinsthal (DE); März, Karin, Dr., W-6500 Mainz (DE)

(56) Entgegenhaltungen:
- EP-A- 339 860
- US-A- 4 885 225

## Beschreibung

Die Erfindung betrifft ein lichtempfindliches, insbesondere photopolymerisierbares Material für die Herstellung von Farbprüffolien für den Mehrfarbendruck. Sie betrifft ferner ein Farbprüfverfahren, bei dem auf einem Bildempfangsmaterial ein Mehrfarbenbild aus mehreren Teilfarbenbildern im Register erzeugt wird. Die Teilfarbenbilder werden durch Laminieren einer in einer Grundfarbe eingefärbten photopolymerisierbaren Schicht auf das Bildempfangsmaterial, Belichten unter dem zugehörigen Farbauszug, Entwickeln des Bilds durch Abziehen der Trägerfolie der photopolymerisierbaren Schicht zusammen mit den Nichtbildstellen und Wiederholen der gleichen Schritte mit einer photopolymerisierbaren Schicht einer anderen Grundfarbe hergestellt.

Ein derartiges Farbprüfverfahren und ein hierfür vorgesehenes Material sind aus den US-A 4 895 787 und 5 049 476 bekannt. Dieses Material besteht aus einer transparenten Trägerfolie, deren Oberfläche vorzugsweise haftvermittelnd vorbehandelt worden ist, einer photopolymerisierbaren Schicht, die einen Farbstoff oder ein Farbpigment in einer Grundfarbe des Mehrfarbendrucks enthält und einer durch Erwärmen aktivierbaren Haftschicht auf der photopolymerisierbaren Schicht. Das Material wird nach Laminieren auf ein Bildempfangsmaterial und Belichten durch die Trägerfolie durch Auseinanderziehen ("peel apart") von Trägerfolie und Bildempfangsmaterial entwickelt, wobei die belichteten Bereiche der lichtempfindlichen Farbschicht an der Trägerfolie, die unbelichteten Bereiche zusammen mit der gesamten Haftschicht auf dem Bildempfangsmaterial verbleiben. Das Verfahren arbeitet also positiv, d. h. auf dem Bildempfangsmaterial entsteht ein positives Abbild der Vorlage.

Dieses Verarbeitungsverfahren hat den großen Vorteil, daß es zur Entwicklung keine alkalischen oder sauren Lösungen und keine organischen Lösemittel erfordert, deren Entsorgung damit entfällt. Ein Nachteil dieses Verfahrens ist der Umstand, daß die thermoplastischen Haftschichten beim Stapeln oder Aufwickeln des Materials eine gewisse Neigung zum Blocken aufweisen. Dies kann dazu führen, daß die Haftschicht nach längerer Lagerung, insbesondere bei erhöhter Temperatur, so stark mit der Rückseite der benachbarten Folie verklebt, daß sie sich davon nicht ohne Beschädigung trennen läßt. Auch beim Laminieren dieser Folien kann es geschehen, daß sich beim Aufeinanderlegen Lufteinschlüsse bilden, die sich wegen der Blockier- bzw. Verklebeneigung der Schichten nicht mehr beseitigen lassen und die dann zu Störungen bei der Verarbeitung führen.

In der US-A 4 889 787 (= EP-A-0 339 860) ist ein lichtempfindliches Material für die Herstellung von Farbprüffolien auf Basis lichtempfindlicher Diazooxide beschrieben, das eine Haftschicht mit einem Gehalt an Kieselsäurepigmenten aufweist. Die dort beschriebenen Pigmente sollen die Blokkierneigung der Haftschicht verhindern und haben demgemäß eine mittlere Teilchengröße, die die Schichtdicke übersteigt. Dieses Material wird durch Auswaschen der Nichtbildstellen zum Bild entwickelt.

In der US-A 4 885 225 ist eine Farbprüffolie aus einem Träger, einer negativ arbeitenden lichtempfindlichen Schicht und einer thermoplastischen Haftschicht beschrieben. Die Haftschicht enthält als Antiblockmittel 0,1 bis 1,0 Gew. an Polymerteilchen, deren mittlerer Durchmesser das 1,5- bis 2fache der Dicke der Haftschicht beträgt. Die Polymerteilchen ragen damit über die Oberfläche der Haftschicht hinaus, was zu Störungen bei der Herstellung des Mehrfarben-Farbprüfbildes führt. Von einer Mattierung mit Hilfe von Kieselsäureteilchen wird abgeraten, da Kieselsäureteilchen der ensprechenden Größe eine unerwünschte Trübung des Farbprüfbildes verursachen.

Aufgabe der Erfindung war es, ein lichtempfindliches Material und ein Farbprüfverfahren der eingangs beschriebenen Gattung zur Verfügung zu stellen, die bei der Verarbeitung durch Laminieren und Auseinanderziehen keine Neigung zum Verkleben und zur Ausbildung von Lufteinschlüssen aufweisen.

Gegenstand der Erfindung ist ein lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag, und
   B4) einen Feststoff oder ein Farbpigment in einer Grundfarbe des Mehrfarbendrucks enthält, und
C) einer thermoplastischen Haftschicht mit einem Schichtgewicht von 2 bis 30 g/m² auf der lichtempfindlichen Schicht.

Das erfindungsgemäße Material ist dadurch gekennzeichnet, daß die thermoplastische Haftschicht 0,01 bis 0,5 Gew.-% eines farblosen Pigments einer mittleren Teilchengröße enthält, die 1 bis 100 % der Schichtdicke entspricht.

Gemäß einem anderen Aspekt der Erfindung wird ein Verfahren zur Herstellung eines Mehrfarbenbilds vorgeschlagen, das dadurch gekennzeichnet ist, daß man ein lichtempfindliches Material der vorstehend angegebenen Zusammensetzung mit der Haftschicht unter Druck auf ein Bildempfangsmaterial laminiert, durch die Trägerfolie hindurch mit einem Farbauszug vor oder nach dem Laminieren bildmäßig belichtet, die Trägerfolie zusammen mit den belichteten Schichtbereichen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

Die Haftschicht des erfindungsgemäßen Materials weist als wesentliches Merkmal einen Gehalt an einem transparenten, farblosen Pigment auf, das eine Teilchengröße in einem bestimmten Bereich hat und in einem Mengenanteil innerhalb eines bestimmten Bereichs vorliegt. Das Pigment kann anorganischer oder organischer Natur sein und muß in dem für die Haftschicht verwendeten Beschichtungslösemittel unlöslich sind. Da als Lösemittel bevorzugt Wasser oder ein Gemisch eingesetzt wird, das überwiegend aus Wasser besteht, sind eine Vielzahl von wasserunlöslichen Substanzen als Pigmente geeignet. Beispiele sind Kieselsäuren, Aluminiumoxide, Silikate, Phosphate, Borate und andere anorganische Salze oder Oxide. Ferner sind organische Polymere, wie Polyethylen, Polypropylen, Polyester, Polycarbonate, Phenolharze und andere wasserunlösliche Substanzen geeignet. Im allgemeinen werden anorganische Pigmente bevorzugt. Das Pigment liegt in einem Mengenanteil von 0,01 bis 0,5 Gew.-% vor, bezogen auf das Gewicht der Haftschicht. Bevorzugt werden Mengenanteile von 0,03 bis 0,3, insbesondere von 0,03 bis 0,2 Gew.-%.

Die mittlere Teilchengröße des Pigments muß kleiner sein als die Schichtdicke. Diese wird gewöhnlich als Schichtgewicht angegeben und liegt im Bereich von 2 bis 30 g/m². Bei einer Dichte von 1 entspricht das 2 bis 30 µm. Die Teilchengröße liegt deshalb allgemein zwischen etwa 0,02 und 30 µm. Bezogen auf die Schichtdicke, beträgt sie allgemein 1 bis 100, vorzugsweise 10 bis 85 und besonders bevorzugt 20 bis 70 % der Schichtdicke.

Teilchen einer Größe, die die Schichtdicke überschreitet, führen dazu, daß die Bildstellen des Teilfarbenbilds, auf das die Haftschicht der nächsten Farbprüffolie laminiert wird, durch das Laminieren beschädigt werden, so daß darin sichtbare Löcher oder andere Beschädigungen entstehen, die die Farbwiedergabe des Teilfarbenbilds verfälschen. Obwohl es generell als notwendig angesehen wird, daß Partikel in Antiblockierschichten wesentlich über die Schichtdicke in ihrer Umgebung herausragen, also eine die allgemeine Schichtdicke deutlich übersteigende Partikelgröße haben, ergeben die Partikel in den Haftschichten des erfindungsgemäßen Materials die gewünschte Antiblockierwirkung überraschenderweise auch dann, wenn ihre Teilchengröße wesentlich geringer ist als die Schichtdicke.

Die Pigmente sollten in den zur Beschichtung eingesetzten, meist wäßrigen Lösungen gut dispergierbar sein. Kieselsäurepigmente, insbesondere solche ohne organische Oberflächenbehandlung, haben sich hierfür besonders bewährt.

Die Haftschicht kann aus einem Lösemittel oder Lösemittelgemisch, das die photopolymerisierbare Schicht nicht anlöst, direkt auf diese aufgebracht und getrocknet werden. Sie kann auch zuerst auf eine temporäre Trägerfolie aufgebracht und von dort durch Laminieren und Abziehen der Trägerfolie auf die photopolymerisierbare Farbschicht übertragen werden. Das direkte Aufbringen aus Lösemitteln auf die photopolymerisierbare Schicht wird bevorzugt. Geeignete Lösemittel, die die Farbschicht nicht anlösen, sind Wasser und gesättigte Kohlenwasserstoffe. Viele Polymere können aus wäßriger Dispersion aufgebracht werden; das Aufbringen aus Lösung wird aber bevorzugt. Hierfür eignen sich z. B. Salze von Polymerem mit Säuregruppen, z. B. Carboxylgruppen. Ein bevorzugtes Beispiel ist eine wäßrig-alkalische Lösung eines Vinylacetat/Crotonsäure-Copolymeren (Mowilith Ct 5). Andere geeignete Polymere sind Polyvinylacetat- oder Polyacrylatdispersionen. Das Polymere sollte eine Erweichungstemperatur im Bereich von 40 bis 200, vorzugsweise von 60 bis 120 °C, und bevorzugt einen Tg-Wert im Bereich von 20 bis 60 °C haben. Die Haftschicht kann außer dem thermoplastischen Polymeren noch Weichmacher, Restlöser, Oberflächenausgleichsmittel, Gleitmittel, Antistatika, optische Aufheller und/oder UV-Absorber enthalten. Ihr Schichtgewicht im trockenen Zustand beträgt normalerweise 2 bis 30, vorzugsweise 4 bis 15 g/m². Geeignete Haftschichten sind auch in der US-A 4 895 787 beschrieben.

Die photopolymerisierbare Schicht des erfindungsgemäßen Materials enthält als wesentliche Bestandteile ein polymeres Bindemittel, eine radikalisch polymerisierbare Verbindung, einen Photoinitiator und einen Farbstoff oder ein Farbpigment in einer Grundfarbe des Mehrfarbendrucks. Beispiele für photopolymerisierbare Schichten dieser allgemeinen Zusammensetzung sind in der US-A 4 895 787 beschrieben, auf die hier Bezug genommen werden soll.

Als Photoinitiatoren sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z. B. Trichlormethyl-s-triazine. Bevorzugt werden 2,3-Bis-aryl-chinoxaline, wie sie in der US-A 3 765 898 beschrieben sind, und 2-Aryl-4,6-bis-trichlormethyl-s-triazine. Die Menge an Photoinitiator bzw. an Photoinitiatorkombination liegt im allgemeinen zwischen 1 und 25, vorzugsweise zwischen 5 und 15 Gew.-%.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittri- und -tetraacrylat oder -methacylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Die Farbstoffe bzw. Farbpigmente werden so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanent-gelb GR (C.I. 21 100), Permanentgelb DHG (C.I. 21 090), Permanentrubin L6B (C.I. 15 850 : 1), Permanent Pink F3B (C.I. 12 433), Hostaperm Pink E (C.I. 73 915), Hostaperm Rotviolett ER (C.I. 46 500), Permanentkarmin FBB (C.I. 12 485), Hostapermblau B2G (C.I. 74 160), Hostapermblau A2R (C.I. 74 160) und Printex^{(R)} 25 (Ruß). Die Pigmente können ggf. zur Erzielung des gewünschten Farbtons abgemischt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm.

Der Mengenanteil des Farbstoffs oder Pigments beträgt im allgemeinen 8 bis 40, vorzugsweise 12 bis 30 Gew.-%.

Die photopolymerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Antistatika, inerte Füllstoffe, optische Aufheller und/oder UV-Absorber, enthalten. Sie hat im allgemeinen ein Schichtgewicht von 0,2 bis 5, bevorzugt 0,3 bis 3 g/m².

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat. Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 µm. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Zur Durchführung des erfindungsgemäßen Verfahrens wird das oben beschriebene lichtempfindliche Material mit der Haftschicht auf ein Bildempfangsmaterial laminiert. Dieses kann aus Kunststoff, kunststoffbeschichtetem Spezialpapier oder aus normalem Bedruckpapier bestehen. Andere weiße und ggf. auch nicht-weiße Empfangsmaterialien können ebenfalls verwendet werden. Ein unter den Laminierbedingungen maßhaltiges Bedruckpapier wird gewöhnlich bevorzugt, da damit ein dem späteren Druck weitgehend nahekommender visueller Eindruck erzielt wird. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130, bevorzugt zwischen 70 und 100 °C. Vor oder bevorzugt nach dem Laminieren wird die photopolymerisierbare Schicht durch die Trägerfolie hindurch bildmäßig, i. a. im Kontakt unter einem Positiv-Farbauszug, in bekannter Weise belichtet. Nach dem Belichten wird die Trägerfolie mit der Hand oder in einer geeigneten Vorrichtung abgezogen. Der Abziehwinkel sollte mindestens 90° betragen, ein Winkel von 180° wird besonders bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives Teilfarbenbild erhalten. Jede weitere Farbprüffolie wird in der beschriebenen Weise auf das vorangehende Teilfarbenbild laminiert, dort im Register belichtet und durch Abziehen der Trägerfolie entwickelt. So wird aus den Teilfarbenbildern der Farben Cyan (Blaugrün), Magenta (Purpur), Gelb und Schwarz ein vollständiges Mehrfarbenbild erzeugt, das dem späteren 4-Farben-Druckbild entspricht. Bei Bedarf können selbstverständlich auch Farbprüffolien in Sonderfarben eingesetzt werden.

Das fertige Mehrfarbenbild hat eine glänzende Oberfläche. Nach Wunsch kann die Oberfläche mattiert werden, indem z. B. eine Folie mit rauher Oberfläche auf die glänzende Schichtoberfläche laminiert und wieder abgezogen wird.

Die Oberfläche des fertigen Prüfbilds kann mit einer Schutzschicht gegen Verkratzen oder Verkleben bei höheren Temperaturen geschützt werden.

Die Erfindung wird durch die folgenden Beispiele erläutert. Alle Prozentangaben und Mengenverhältnisse sind in Gewichtseinheiten zu verstehen.

### Beispiel 1

Beschichtungslösungen der folgenden Zusammensetzung wurden auf 50 µm dicke biaxial verstreckte und thermofixierte Polyethylenterephthalatfolien, die auf beiden Seiten zur Haftverbesserung vorbehandelt waren (Melinex^{(R)} 454) aufgebracht und getrocknet:

| Bestandteil | Gewichtsteile | | | |
|---|---|---|---|---|
| | Blaugrün | Purpur | Gelb | Schwarz |
| Dipentaerythritpentaacrylat | 39,0 | 35,5 | 38,2 | 36,1 |
| Polyvinylformal (Formvar^{(R)} 12/85) | 31,3 | 36,5 | 35,4 | 28,9 |
| 2-Diphenylyl-(4)-4,6-bis-trichlormethyl-s-triazin | 9,8 | 7,8 | 9,5 | 9,6 |
| Hostapermblau B2G (C.I.74160) | 19,0 | -- | -- | -- |
| Permanentcarmin FBB (C.I.12485) | -- | 18,5 | -- | -- |
| Permanentgelb GR (C.I.21100) | -- | 0,7 | 16,4 | -- |
| Ruß (Printex ^{(R)} 25) | 0,4 | 0,5 | -- | 24,8 |
| Silikonöl als Verlaufmittel (Edaplan ^{(R)} La 411) | 0,5 | 0,5 | 0,5 | 0,6 |
| Tetrahydrofuran | 1000 | 1000 | 1000 | 1000 |
| 1-Methoxy-propan-2-ol | 680 | 680 | 680 | 680 |
| Butyrolacton | 190 | 190 | 190 | 190 |

Die Farbpigmente wurden zuerst in einer Lösung eines Teils des Polyvinylformals in Butyrolacton dispergiert und zu einer mittleren Teilchengröße von weniger als 0,2 µm vermahlen. Das Trockenschichtgewicht der vier Folien war wie folgt:

| | |
|---|---|
| Blaugrün | 0,58 g/m² |
| Purpur | 0,83 " |
| Gelb | 0,75 " |
| Schwarz | 0,67 " |

Auf die lichtempfindliche Schicht wurde jeweils eine Haftschichtlösung von

| | |
|---|---|
| 96,57 Gt | Vinylacetat/Crotonsäure-Mischpolymerisat (95:5) |
| 1,93 Gt | Polyvinylmethylether, |
| 1,36 Gt | Natriumsulfit und |
| 0,15 Gt | pyrogener Kieselsäure, mittlere Teilchengröße 3 µm, (Syloid^{(R)} ED 3) in |
| 520 Gt | Wasser, |
| 43 Gt | Ethanol und |
| 8,5 Gt | wäßrigem Ammoniak (25 %) |

aufgebracht und zu einem Schichtgewicht von 6,5 g/m² getrocknet.

Die erhaltenen lichtempfindlichen Farbprüffolien zeigten kein Blocken, wenn sie 24 Stunden bei 50 °C Haftschicht auf Folienrückseite oder Haftschicht auf Haftschicht gelagert wurden. Nach 5 Tagen bei 50 °C begannen die Haftschicht auf Haftschicht gelagerten Folien zu blocken, während die Haftschicht auf Folienrückseite gelagerten noch immer kein Anzeichen von Blocken zeigten.

Die Blaugrünfolie wurde in einer Vorrichtung mit einem beheizten Walzenpaar bei 85 °C mit der Haftschicht auf ein Empfangsblatt aus Papier laminiert und unter einem Blaugrün-Farbauszug durch die Trägerfolie hindurch belichtet. Dann wurde die Trägerfolie von dem Empfangsblatt abgezogen, wobei die unbelichteten Schichtbereiche zusammen mit der Haftschicht auf dem Empfangsblatt zurückblieben. In gleicher Weise wurden nacheinander die Purpur-, Gelb- und Schwarz folie auf das Empfangsblatt über das vorhergehende Teilfarbenbild laminiert, unter dem entsprechenden Farbauszug registergerecht belichtet und durch Abziehen der Trägerfolie entwickelt. Beim Laminieren der jeweils folgenden Farbprüffolien auf das vorhergehende Teilfarbenbild wurden keine Lufteinschlüsse gebildet, weil die Haftschicht der neuen Folie nicht vor dem Erreichen des Walzenspalts mit dem Teilfarbenbild blockte. Auf diese Weise wurde ein Vierfarbenbild auf dem Empfangsblatt erhalten, das der ursprünglichen Vorlage entsprach. Die Auflösung betrug - unabhängig von der Abzugsrichtung der Trägerfolie - mindestens 15 µm. In einem Raster von 60 Linien/cm wurden die Rasterpunkte von 2 bis 98 % wiedergegeben.

### Vergleichsbeispiel A

Beispiel 1 wurde wiederholt, wobei das Kieselsäurepigment aus der Haftschicht weggelassen wurde. Die erhaltenen Farbprüffolien blockten, wenn sie 15 Minuten bei 50 °C entweder Haftschicht auf Haftschicht oder Haftschicht auf Folienrückseite gelagert wurden. Beim Laminieren der nächstfolgenden Farbprüffolie auf das Empfangsblatt mit dem vorhergehenden Teilfarbenbild entstanden Lufteinschlüsse, weil die Schichten vor dem Erreichen des Walzenspalts bereits miteinander verklebten.

### Vergleichsbeispiel B

Vergleichsbeispiel A wurde wiederholt, wobei die doppelseitig haftvermittelten Polyesterfolien (Melinex 454) durch einseitig haftvermittelte und auf der anderen Seite mit einer Antiblockierschicht versehene Polyesterfolien (Melinex 6057) ersetzt wurden. Die lichtempfindlichen Schichten wurden auf die haftvermittelte Seite aufgebracht. Die erhaltenen Farbprüffolien blockten, wenn sie 15 Minuten bei 50 °C Haftschicht auf Haftschicht oder wenn sie 1 Stunde bei 50 °C Haftschicht auf Folienrückseite gelagert wurden. Wie im Vergleichsbeispiel A wurden Lufteinschlüsse beim Laminieren gebildet.

### Vergleichsbeispiel C

Farbprüffolien wurden hergestellt, wie in Beispiel 1 beschrieben, jedoch wurden die Kieselsäurepartikel in der Haftschicht durch entsprechende Partikel mit einer mittleren Teilchengröße von 9 µm ersetzt (Syloid 621). Das Schichtgewicht der Haftschicht war ebenfalls 6,5 g/m². Die Farbprüffolien blockten nicht, wenn sie mehr als 24 Stunden bei 50 °C Haftschicht auf Haftschicht gelagert wurden. Beim Laminieren entstanden keine Lufteinschlüsse; es wurden aber kleine Löcher in die Bildelemente des vorher erzeugten Teilfarbenbilds gerissen, die durch die großen Partikel der darauf aufgebrachten Haftschicht verursacht wurden.

### Vergleichsbeispiel D

Es wurde wie in Vergleichsbeispiel C gearbeitet, jedoch wurde das Kieselsäurepigment durch ein entsprechendes Pigment mit einer mittleren Teilchengröße von 0,04 µm ersetzt (Aerosil ^{(R)} 0X50). Die Farbprüffolien blockten nach 30 Minuten bei 50 °C, wenn sie Haftschicht auf Haftschicht gelagert wurden, und nach 1 Stunde, wenn sie Haftschicht auf Folienrückseite gelagert wurden. Beim Laminieren bildeten sich einige Lufteinschlüsse.

### Beispiel 2

Es wurde wie in Beispiel 1 gearbeitet, jedoch wurden Haftschichten mit einem Schichtgewicht von 10,5 g/m² aufgebracht. Die Farbprüffolien blockten nicht, wenn sie mehr als 24 Stunden bei 50 °C Haftschicht auf Haftschicht oder Haftschicht auf Folienrückseite gelagert wurden. Es wurden weder Lufteinschlüsse noch Löcher in den Bildstellen beim Laminieren beobachtet.

### Beispiel 3

Es wurde wie in Beispiel 1 gearbeitet, jedoch wurde in der Haftschicht die Menge des Polyvinylethers erhöht. Die Zusammensetzung dieser Schicht war wie folgt:

| | |
|---|---|
| 93,86 Gt | Vinylacetat-Mischpolymerisat, |
| 4,69 " | Polyvinylmethylether, |
| 1,31 " | Natriumsulfit und |
| 0,14 " | Syloid ED3 |

Das Schichtgewicht betrug 6,5 g/m². Die erhaltenen Farbprüffolien blockten nicht, wenn sie mehr als 24 Stunden bei 50 °C Haftschicht auf Haftschicht oder Haftschicht auf Folienrückseite gelagert wurden. Es wurden weder Lufteinschlüsse noch Löcher in den Bildstellen der Teilfarbenbilder nach dem Laminieren beobachtet.

### Beispiel 4

In diesem Beispiel wurde als Empfangsblatt ein rauhes Papier eingesetzt, das eine Vorbeschichtung aus Polyvinylacetat (Mowilith 20) von 17 g/m² trug. Entsprechend vorbeschichtete Empfangsblätter sind in der US-A 4 910 120 beschrieben.

Farbprüffolien gleicher Zusammensetzung wie in Beispiel 1 wurden hergestellt. In diesem Beispiel wurde jedoch zuerst die Schwarz-Folie, dann die Purpur-Folie, die Gelb-Folie und schließlich die Blaugrün-Folie auf die vorbeschichtete Seite des Empfangsblatts laminiert. Die Verarbeitung durch Belichten und Abziehen der Trägerfolien erfolgte wie in Beispiel 1. Das erhaltene Mehrfarbenbild war eine genaue Wiedergabe des Originals.

### Vergleichsbeispiel E

Beispiel 4 wurde wiederholt, jedoch wurde das Kieselsäurepigment aus der Haftschicht weggelassen. Die erhaltenen Farbprüffolien blockten nach 15 Minuten Lagerung bei 50 °C Haftschicht auf Haftschicht oder Haftschicht auf Folienrückseite. Nach dem Laminieren waren keine Löcher in den Teilfarbenbildern erkennbar, jedoch zeigten sich Lufteinschlüsse.

### Beispiel 5

Es wurde wie in Beispiel 1 gearbeitet, jedoch wurde in der Haftschicht jeweils das Kieselsäurepigment durch die gleiche Menge eines Gemischs von 42 Gewichtsteilen Kieselsäure und 36 Gewichtsteilen Aluminiumoxid mit einer mittleren Teilchengröße von 3,5 µm ersetzt. Die erhaltenen Farbprüffolien blockten nicht, wenn sie mehr als 24 Stunden bei 50 °C Haftschicht auf Haftschicht oder Haftschicht auf Folienrückseite gelagert wurden. Weder Löcher in dem Bildelementen noch Lufteinschlüsse wurden beobachtet.

## Patentansprüche

1. Lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
B1) ein polymeres Bindemittel,
B2) eine radikalisch polymerisierbare Verbindung,
B3) eine Verbindung, die unter Einwirkung von aktinischem Licht die Polymerisation von (B2) einzuleiten vermag, und
B4) einen Farbstoff oder ein Farbpigment in einer Grundfarbe des Mehrfarbendrucks enthält, und
C) einer thermoplastischen Haftschicht mit einem Schichtgewicht von 2 bis 30 g/m² auf der lichtempfindlichen Schicht,
dadurch gekennzeichnet, daß die thermoplastische Haftschicht 0,01 bis 0,5 Gew.-% eines farblosen Pigments einer mittleren Teilchengröße enthält, die 1 bis 100 % der Schichtdicke entspricht.

2. Lichtempfindliches Material nach Anspruch 1, dadurch gekennzeichnet, daß die Teilchengröße 10 bis 85 % der Schichtdicke entspricht.

3. Lichtempfindliches Material nach Anspruch 1, dadurch gekennzeichnet, daß das farblose Pigment ein anorganisches Pigment ist.

4. Lichtempfindliches Material nach Anspruch 1, dadurch gekennzeichnet, daß die thermoplastische Haftschicht 0,03 bis 0,3 % Pigment enthält.

5. Lichtempfindliches Material nach Anspruch 1, dadurch gekennzeichnet, daß die thermoplastische Haftschicht eine Glastemperatur Tg von 20 bis 100 °C hat.

6. Lichtempfindliches Material nach Anspruch 1, dadurch gekennzeichnet, daß die radikalisch polymerisierbare Verbindung mindestens zwei polymerisierbare Gruppen enthält.

7. Lichtempfindliches Material nach Anspruch 1, dadurch gekennzeichnet, daß die radikalisch polymerisierbare Verbindung ein Acryl- oder Methacrylsäureester ist.

8. Lichtempfindliches Material nach Anspruch 1, dadurch gekennzeichnet, daß die photopolymerisierbare Schicht ein Gewicht von 0,2 bis 5 g/m² hat.

9. Verfahren zur Herstellung eines Mehrfarbenbilds, dadurch gekennzeichnet, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszug vor oder nach dem Laminieren bildmäßig belichtet, die Trägerfolie zusammen mit den belichteten Schichtbereichen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

10. Verfahren nach Anspruch 9, dadurch gekennzeichnet, daß das Bildempfangsmaterial Papier ist.

11. Verfahren nach Anspruch 10, dadurch gekennzeichnet, daß das Papier ein übliches Bedruckpapier ist, wie es für den Auflagendruck mit den entsprechenden Flachdruckplatten eingesetzt wird.

## Claims

1. Photosensitive material for the production of colour proof sheets for multi-colour printing with
A) a transparent flexible support film of plastics material,
B) a photopolymerisable layer which contains
B1) a polymeric binder,
B2) a radically polymerisable compound,
B3) a compound which is capable of initiating the polymerisation of (B2) under the effect of actinic light, and
B4) a dye or a colour pigment in a basic colour of multi-colour printing, and
C) a thermoplastic adhesive layer with a layer weight of 2 to 30 g/m² on the photosensitive layer,
characterised in that the thermoplastic adhesive layer contains 0.01 to 0.5 wt % of a colourless pigment of an average particle size which corresponds to 1 to 100% of the layer thickness.

2. Photosensitive material according to claim 1, characterised in that the particle size corresponds to 10 to 85% of the layer thickness.

3. Photosensitive material according to claim 1, characterised in that the colourless pigment is an inorganic pigment.

4. Photosensitive material according to claim 1, characterised in that the thermoplastic adhesive layer contains 0.03 to 0.3% of pigment.

5. Photosensitive material according to claim 1, characterised in that the thermoplastic adhesive layer has a glass temperature Tg of 20 to 100 °C.

6. Photosensitive material according to claim 1, characterised in that the radically polymerisable compound contains at least two polymerisable groups.

7. Photosensitive material according to claim 1, characterised in that the radically polymerisable compound is an acrylic or methacrylic acid ester.

8. Photosensitive material according to claim 1, characterised in that the photopolymerisable layer has a weight of 0.2 to 5 g/m².

9. Process for producing a multi-coloured image, characterised in that a photosensitive material with the composition given in claim 1 is laminated with the adhesive layer under pressure onto an image receiving material, is exposed image-wise through the support film with a colour separation before or after the lamination, the support film is withdrawn from the image receiving material together with the exposed layer areas and the steps lamination, exposure and withdrawal are repeated with at least one further colour separation, wherein the exposure takes place in the register with the first partly coloured image produced on the image receiving material.

10. Process according to claim 9, characterised in that the image receiving material is paper.

11. Process according to claim 10, characterised in that the paper is a conventional printing paper such as is used for production printing with the corresponding offset printing plates.

## Revendications

1. Matériau photosensible pour la fabrication de feuilles d'épreuves couleurs pour la polychromie, comprenant
A) une feuille de support flexible transparente constituée d'une matière synthétique,
B) une couche photopolymérisable qui contient
B1) un liant polymère,
B2) un composé apte à une polymérisation par voie radicalaire,
B3) un composé qui, sous l'influence de la lumière actinique, permet de déclencher la polymérisation de (B2), et
B4) un colorant ou un pigment-coloré en une couleur primaire de l'imprimé polychrome, et
C) une couche adhésive thermoplastique appliquée sur la couche photosensible à raison de 2 à 30 g/m²,
caractérisé en ce que la couche adhésive thermoplastique contient, à concurrence de 0,01 à 0,5% en poids, un pigment incolore possédant une granulométrie moyenne qui représente de 1 à 100% de l'épaisseur de la couche.

2. Matériau photosensible selon la revendication 1, caractérisé en ce que la granulométrie représente de 10 à 85% de l'épaisseur de la couche.

3. Matériau photosensible selon la revendication 1, caractérisé en ce que le pigment incolore est un pigment inorganique.

4. Matériau photosensible selon la revendication 1, caractérisé en ce que la couche adhésive thermoplastique contient un pigment à concurrence de 0,03 à 0,3%.

5. Matériau photosensible selon la revendication 1, caractérisé en ce que la couche adhésive thermoplastique possède une température de transition vitreuse Tg de 20 à 100°C.

6. Matériau photosensible selon la revendication 1, caractérisé en ce que le composé apte à une polymérisation par voie radicalaire contient au moins deux groupes polymérisables.

7. Matériau photosensible selon la revendication 1, caractérisé en ce que le composé polymérisable par voie radicalaire est un ester d'acide acrylique ou d'acide méthacrylique.

8. Matériau photosensible selon la revendication 1, caractérisé en ce que la couche photopolymérisable possède un poids de 0,2 à 5 g/m².

9. Procédé pour la fabrication d'une image polychrome, caractérisé en ce qu'on stratifie un matériau photosensible possédant la composition indiquée à la revendication 1, avec la feuille adhésive, sous pression, sur un matériau de réception d'image; on l'expose en forme d'image à travers la feuille de support à une sélection de couleur avant ou après la stratification; on pellicule du matériau de réception d'image la feuille de support conjointement avec les zones exposées de la couche; et on répète les étapes de stratification, d'exposition et de pelliculage avec au moins une autre sélection de couleur; dans lequel l'exposition a lieu en registre avec la première image de sélection partielle obtenue sur le matériau de réception d'image.

10. Procédé selon la revendication 9, caractérisé en ce que le matériau de réception d'image est du papier.

11. Procédé selon la revendication 10, caractérisé en ce que le papier est un papier d'impression habituel tel qu'on le met en oeuvre pour l'impression par tirage avec les clichés d'impression planographique correspondants.
